# EUROPEAN PATENT APPLICATION

(11) **EP 4 749 363 A1**
(43) Date of publication of application: **27.05.2026**
(21) Application number: 24215229.6
(22) Date of filing: 25.11.2024
(51) Int. Cl.: G03F 1/44, G03F 7/00

(54) **METROLOGY TARGET**

(71) Applicant: ASML Netherlands B.V., 5500 AH Veldhoven (NL)
(72) Inventor: MCCABE, Alexander, Iain, Veldhoven (NL); VERMA, Alok, Veldhoven (NL)
(74) Representative: ASML Netherlands B.V.

(57) **Abstract**

A new metrology target configured for measuring a parameter of a patterning process comprises first and second portions. The first and second portions comprise substantially the same pattern in a first direction, the first and second portions are each periodic in a first direction, have a first pitch (p₁) in the first direction and have a unit cell in the first direction comprising a set of at least two gratings. The first and second portions are generally mutually interleaved such that at least in a central portion of the metrology target, each set of at least two gratings of one of the first and second portions is positioned between two adjacent sets of at least two gratings of the other one of the first and second portions. The first and second portions have the different pattern (for example one or more cuts) in a second direction that is generally perpendicular to the first direction.

## Description

### FIELD

The present invention relates to a new metrology target configured for measuring a parameter of a patterning process. The present invention also relates to a new method for forming a metrology target configured for measuring a parameter of a patterning process. The present invention also relates to a kit of parts for forming a metrology target configured for measuring a parameter of a patterning process. The present invention also relates to a patterning device for forming a metrology target. The present invention also relates to a new computer program product for forming a metrology target configured for measuring a parameter of a patterning process.

### BACKGROUND

An exposure apparatus is a machine constructed to apply a desired pattern onto a substrate. An exposure lithographic apparatus can be used, for example, in the manufacture of integrated circuits (ICs). An example of an exposure apparatus is a lithographic apparatus. A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

It may be desirable to provide new metrology targets and associated methods for forming such targets that at least partially addresses one or more problems associated with known arrangements, whether such problems are identified herein or otherwise.

### SUMMARY

According to a first aspect of the present disclosure there is provided a metrology target configured for measuring a parameter of a patterning process comprising: a first portion at least partially formed by a first patterning process; and a second portion at least partially formed by a second patterning process; wherein the first and second portions comprise substantially the same pattern in a first direction, the first and second portions are each periodic in a first direction, have a first pitch (p₁) in the first direction and have a unit cell in the first direction comprising a set of at least two gratings; wherein the first and second portions are generally mutually interleaved such that at least in a central portion of the metrology target, each set of at least two gratings of one of the first and second portions is positioned between two adjacent sets of at least two gratings of the other one of the first and second portions; and wherein the first and second portions have the different pattern in a second direction that is generally perpendicular to the first direction.

An example of a parameter of a patterning process is misalignment of a first patterning process and a second patterning process. In the art such a misalignment is referred to as "overlay".

An example of a grating is a single line, a pair of lines, or a set of more lines, for example a set of 4 lines.

The metrology target according to the first aspect of the present disclosure may be of a type referred to as an in device metrology (IDM) target. Typically such IDM targets may have features with dimensions that are comparable to those of features in the devices formed during the patterning processes e.g. lithographic exposures. Such a target may be difficult, or impractical, to resolve optically using traditional metrology techniques. Such a target can be measured using, for example, a scanning electron microscope (SEM) however there are a number of problems associated with such measurements including, for example, that the process is partially manual and is therefore susceptible to errors.

The metrology target according to the first aspect of the present disclosure may be used to determine a parameter of a patterning process optically as follows. Radiation may be projected onto and scattered by the target. For example, the target may be under-filled i.e., the radiation spot is smaller than the target. An asymmetry of reflected (or zeroth order scattered) radiation in a pupil plane (i.e. a Fourier transform plane to the plane of the target) is determined. This asymmetry is correlated to overlay and therefore overlay can be determined from the asymmetry. The parameter of a patterning process may, for example, be determined using metrology apparatus and/or methods of the type disclosed in WO2017/149009, which is incorporated herein by reference in its entirety.

The metrology target according to the first aspect of the present disclosure is advantageous for a number of reasons, as now discussed. In particular, the metrology target according to the first aspect of the present disclosure allows for a simple optical measurement of a parameter of a patterning process for processes that combine self-aligned double patterning (SADP) methods and litho-etch-litho-etch (LELE) methods. Combining SADP and LELE methods allows for a significant increase in the density of features that can be formed using a given wavelength and the metrology target according to the first aspect of the present disclosure enables such a process by allowing for accurate measurements to be made.

Each of the first and second portions have a unit cell in the first direction comprising a set of at least two gratings. Each such set of gratings is at least partially formed by a patterning process. In particular, each such set of gratings may be formed using a self-aligned double patterning (SADP) or spacer patterning method. For example, each such set of gratings may comprise 4 lines and may be formed using a self-aligned quadruple patterning (SAQP) method. Furthermore, since the first and second portions are generally mutually interleaved the gratings from each of the first and second portions of the metrology target according to the first aspect of the present disclosure generally do not overlap. Such an arrangement is particularly beneficial for measuring overlay between two exposures that are formed in a single exposure layer (via two or more separate exposures). Such an exposure process may be referred to as a litho-etch-litho-etch (LELE) process. With such an LELE process product features formed on the current layer of the wafer may comprise two portions (which are formed using separate exposures) and which are substantially identical. In general, it may be beneficial for marks to be similar (for example as similar as possible) to the features formed on products being exposed in the current exposure layer. Since the first and second portions of the metrology target according to the first aspect of the present disclosure (which are at least partially formed during separate patterning process) comprise substantially the same pattern in the first direction they can be as similar to product features as possible. In fact, they can each be partially formed from patterns on a reticle that are identical to patterns on a reticle that are used for the formation of process features. Subsequently, at least one of the first and second portions may be subject to one or more cuts such that the first and second portions have the different pattern in the second direction.

The first and second portions have the different pattern in a second direction that is generally perpendicular to the first direction and, advantageously, this ensures that any asymmetry of the first and second portions is correlated to overlay of the two patterning processes, allowing overlay to be measured. In particular, they ensure that there is a correlation between a misalignment of the first and second patterning process (i.e. overlay) and an asymmetry of a radiation beam reflected by the metrology target.

The first portion and the second portion may be formed in the same exposure layer of an object.

In the art, a litho-etch-litho-etch process (LELE) is the formation of a single layer using multiple patterning processes. At present, metrology targets for such LELE processes are typically measured using a scanning electron microscopes.

Each set of at least two gratings of the first portion and the second portion may be formed using a self-aligned double patterning method.

Such a method may alternatively be referred to as a spacer patterning method. For example, each such set of gratings may comprise 4 lines and may be formed using a self-aligned quadruple patterning (SAQP) method.

For example, the first patterning process may form a single grating in each unit cell of the first portion. Similarly, the second patterning process may form a single grating in each unit cell of the second portion. Subsequently, a self-aligned double patterning (SADP) method may be used to convert each such line into at least two lines.

The gratings of the first portion and the second portion may have a dimension that is of the same order of magnitude as product features.

This is advantageous since, in practice, the first and second patterning processes may be optimized for printing product features. Therefore, the closer the metrology target is in structure to such product features the better the mark will be imaged.

Each set of at least two gratings of the first and second portions may be periodic in the first direction and may have a second pitch (p₂).

In some embodiments, the second pitch (p₂) may be of the order of 50 nm or less.

Each set of at least two gratings of the first and second portions may comprise n lines and a pitch (p₂) of each set of gratings in the first direction may be the first pitch divided by 2n (p₂=p₁/2n).

The first and second portions of the metrology target of the first aspect of the present disclosure have the different pattern in the second direction. This may be achieved in a number of different ways. For example, the sets of at least two gratings of the first portion may have different lengths to those of the second portion. Additionally or alternatively, the sets of at least two gratings of at least one of the first portion and the second portion may be cut to form one or more breaks in the gratings.

A least one of the first and second portions may comprise one or more additional features in the second direction.

The one or more additional features may comprise a segmentation of the sets of at least two gratings of at least one of the first and second portions.

The segmentation may comprise a line-cut and/or a fin-cut.

According to a second aspect of the present disclosure there is provided a method for forming an configured for measuring a parameter of a patterning process target comprising first and second portions, the method comprising: performing a first patterning process to at least partially form the first portion; and performing a second patterning process to at least partially form the second portion; wherein the first and second portions comprise substantially the same pattern in a first direction, the first and second portions are each periodic in a first direction, have a first pitch (p₁) in the first direction and have a unit cell in the first direction comprising a set of at least two gratings; wherein the first and second portions are generally mutually interleaved such that at least in a central portion of the metrology target, each set of at least two gratings of one of the first and second portions is positioned between two adjacent sets of at least two gratings of the other one of the first and second portions; and wherein the first and second portions have the different pattern in a second direction that is generally perpendicular to the first direction.

The first portion and the second portion may be formed in the same exposure layer of an object.

In the art, a litho-etch-litho-etch process (LELE) is the formation of a single layer using multiple patterning processes. At present, metrology targets for such LELE processes are typically measured using a scanning electron microscopes.

Each set of at least two gratings of the first portion and the second portion may be formed using a self-aligned double patterning method.

Such a method may alternatively be referred to as a spacer patterning method. For example, each such set of gratings may comprise 4 lines and may be formed using a self-aligned quadruple patterning (SAQP) method.

For example, the first patterning process may form a single grating in each unit cell of the first portion. Similarly, the second patterning process may form a single grating in each unit cell of the second portion. Subsequently, a self-aligned double patterning (SADP) method may be used to convert each such grating into at least two gratings.

The gratings of the first portion and the second portion may have a dimension that is of the same order of magnitude as product features.

This is advantageous since, in practice, the first and second patterning processes may be optimized for printing product features. Therefore, the closer the metrology target is in structure to such product features the better the mark will be imaged.

Each set of at least two gratings of the first and second portions may be periodic in the first direction and may have a second pitch (p₂).

In some embodiments, the second pitch (p₂) may be of the order of 50 nm or less.

The method may further comprise at least one additional patterning process to form features in at least one of the first and second portions in the second direction.

The one or more additional features may comprise a segmentation of the sets of at least two gratings of at least one of the first and second portions.

The segmentation may comprise a line-cut and/or a fin-cut.

According to a third aspect of the present disclosure there is provided a kit of parts for forming the metrology target according to the first aspect of the present disclosure, the kit of parts comprising: at least one first patterning device for forming the first portion of the metrology target; and at least one second patterning device for forming the second portion of the metrology target.

The kit of parts may comprise at least two patterning devices for forming at least one of the first portion of the metrology target and the second portion of the metrology target.

For example, a patterning device (a mask or reticle) may be provided for forming a periodic pattern in the first direction and another patterning device (a mask or reticle) may be provided for forming one or more cuts in a second direction.

According to a fourth aspect of the present disclosure there is provided a patterning device for forming the metrology target according to the first aspect of the present disclosure.

According to a fifth aspect of the present disclosure there is provided a computer program product comprising a computer non-transitory readable medium having a data structure recorded thereon, the data structure corresponding to the metrology target according to the first aspect of the present disclosure and/or the method according to the second aspect of the present disclosure.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 is a schematic illustration of a metrology apparatus, such as a scatterometer, comprising a radiation projector and a spectrometer detector;
- Figures 5(a), 5(b), 5(c) and 5(d) comprise (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 6 depicts an alignment sensor;
- Figures 7A to 7D are schematic representations of a process for forming a pattern by exposure of a substrate (for example coated with a layer of resist) in a exposure apparatus;
- Figures 8A to 8E are schematic representations of a sidewall assisted double patterning (SADP) process using an intermediate pattern feature having sidewalls that are generally perpendicular to a plane of the substrate to form pattern features having half the pitch of the intermediate pattern features;
- Figure 9A shows a first portion of a first example of a new type of metrology target according to an embodiment of the present disclosure;
- Figure 9B shows a second portion of the first example of the new type of metrology target according to an embodiment of the present disclosure;
- Figure 9C shows the first example of the new type of metrology target according to an embodiment of the present disclosure (comprising the first portion shown in Figure 9A and the second portion shown in Figure 9B);
- Figure 10A shows an initial pattern comprising sets of gratings of 4 lines separated by a gap from which the second portion of the new metrology target (shown in Figure 9B) may be initially formed;
- Figure 10B shows schematically how the initial pattern shown in Figure 10A may be modified by making one or more cuts through each set of gratings;
- Figure 10C shows the second portion of the new metrology target from by making the cuts shown schematically in Figure 10B;
- Figure 11 shows a second example of the new type of metrology target according to an embodiment of the present disclosure; metrology targetmetrology targetmetrology targetmetrology targetmetrology targetmetrology target-

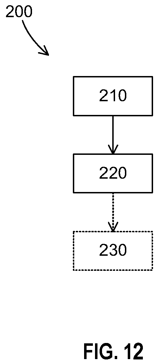

   Figure 12 schematically shows a method for forming an metrology target of the type shown in Figures 9C and 11 according to an embodiment of the present disclosure.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

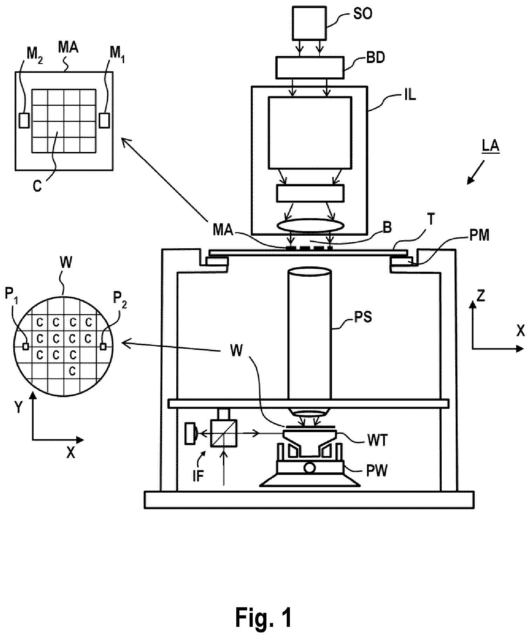

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

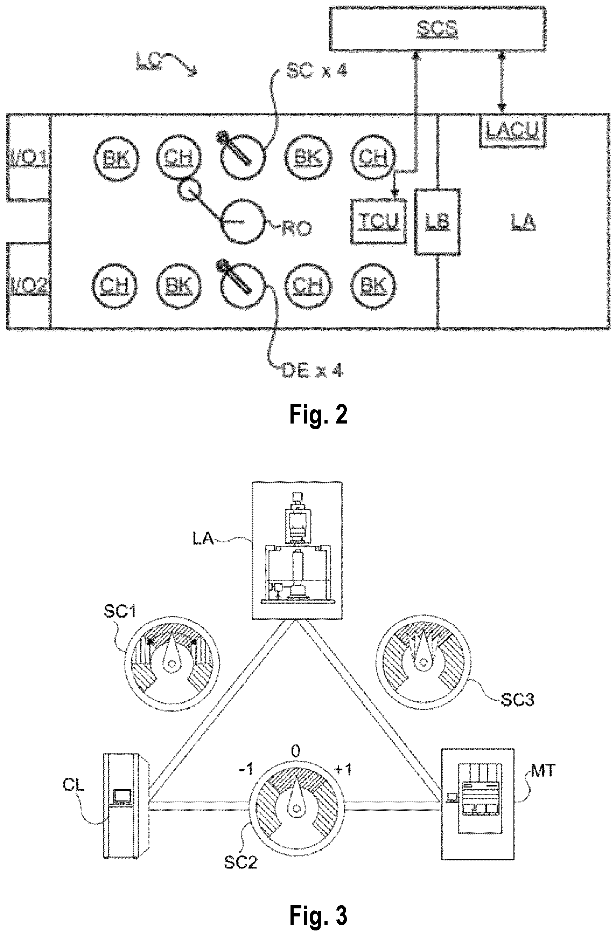

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In exposure processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of an exposure process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of an exposure process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by an exposure process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the exposure process. This reconstruction may be used to provide guidance of the quality of the exposure process and may be used to control at least part of the exposure process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of an exposure parameter using a specific target is at least partially determined by the measurement recipe used to measure this exposure parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

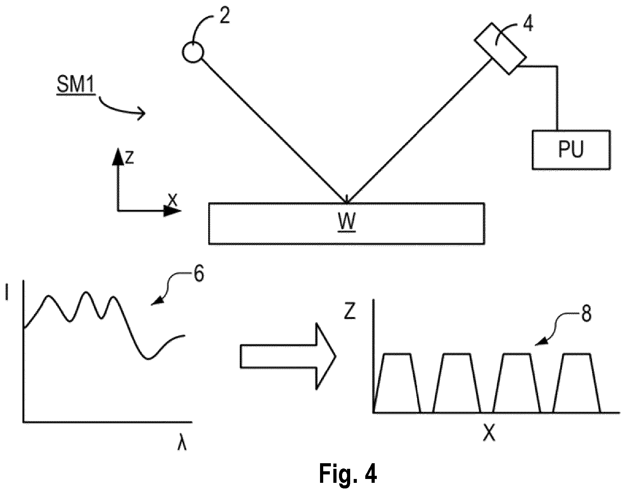

A metrology apparatus, such as a scatterometer, is depicted in Figure 4. It comprises a broadband (white light) radiation projector 2 which projects radiation onto a substrate 6. The reflected or scattered radiation is passed to a spectrometer detector 4, which measures a spectrum 10 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In exposure processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometter illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of an exposure process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032, US 2006033921, US 2010201963 or EP1,628,164A, incorporated herein by reference in their entirety. Aforementioned scatterometers can measure in one image multiple targets from from multiple gratings using light from soft x-ray and visible to near-IR wave range.

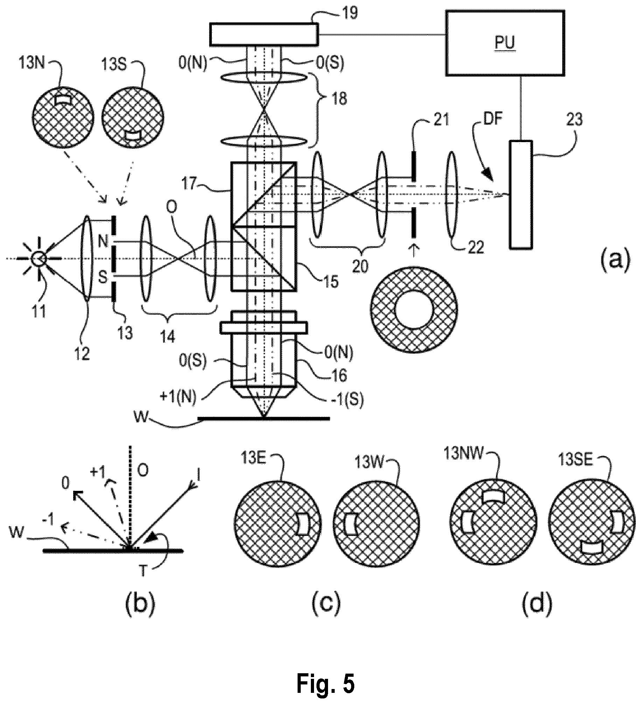

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in the lithographic apparatus LA, e.g., at the measurement station, another exposure apparatus, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction. In an embodiment, an aperture is provided in the optical system 18 to filter out certain diffraction orders so that a particular diffraction order is provided to the first sensor 19. In an embodiment, the aperture allows substantially or primarily only zeroth order radiation to reach the sensor 19.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

In order to provide a customized field of view for different sizes and shapes of grating, an adjustable field stop is provided within the lens system 14 on the path from source 110 to the objective lens 16. The field stop contains an aperture and is located in a plane conjugate with the plane of the target T, so that the illumination spot becomes an image of the aperture. The image may be scaled according to a magnification factor, or the aperture and illumination spot may be in 1: 1 size relation. In order to make the illumination adaptable to different types of measurement, the aperture plate may comprise a number of aperture patterns formed around a disc, which rotates to bring a desired pattern into place. Alternatively or in addition, a set of plates could be provided and swapped, to achieve the same effect. Additionally or alternatively, a programmable aperture device such as a deformable mirror array or transmissive spatial light modulator can be used also.

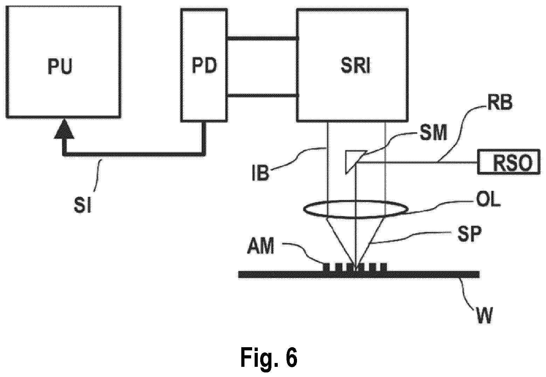

Figure 6 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and de-multiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

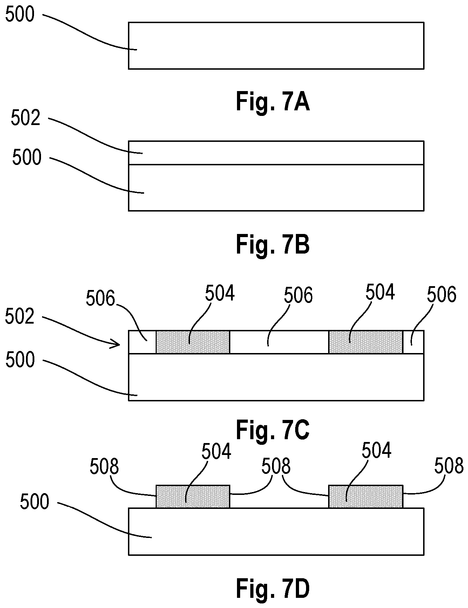

As discussed further below, some embodiments of the present disclosure may comprise one or more features formed using self-aligned double patterning (SADP) processes (also referred to as sidewall assisted double patterning processes). Such processes are outlined briefly below with reference to Figures 7A to 8E.

First an intermediate pattern feature may be formed. The intermediate pattern feature may comprise a pattern formed by exposure of a substrate (for example coated with a layer of resist) in a exposure apparatus, as now described with reference to Figures 7A to 7D.

Figure 7A schematically depicts a substrate 500. The substrate may be, for example similar or identical to the substrate W described in relation to Figure 1. Figure 7B schematically depicts the provision of a first layer of material 502 on a surface of the substrate 500. The first layer of material 502 comprises a photoresist which undergoes some change in properties upon receipt of a dose of radiation exceeding a threshold value. The first layer of material 502 may be referred to as a sacrificial layer, since this layer will be sacrificed (removed) at a later stage during the process. Provision of the first layer of material 502 on the surface of the substrate 500 may be performed within a lithographic cell LC of the type shown in Figure 2 and described above (for example using spin coaters SC). The first layer of material 502 is exposed to a beam of radiation (e.g. a patterned beam of radiation) in order to form intermediate pattern features in the first layer of material 502.

Parts of the first layer of material 502 which receive a dose of radiation above a threshold value undergo a change in properties. In particular, as shown schematically in Figure 7C, after exposure to the patterned radiation beam, the first layer of material 502 may be considered to comprise a first set of parts 504 and a second set of parts 506, wherein one of the first and second set of parts 504, 506 has received a dose of radiation above the threshold value and wherein the other one of first and second set of parts 504, 506 has not received a dose of radiation above the threshold value. After exposure in the lithographic apparatus LA, the intermediate pattern feature (which may comprise the first set of parts 504 of the first layer of material 502) may be considered to be formed even before the second set of parts 506 of the first layer of material 502 have been removed. This is because properties of the first set of parts 504 of the first layer of material 502 differ from those of the second set of parts 506 of the first layer of material 502.

The first layer of material 502 is then developed. Figure 7D shows the substrate 500 once the first layer of material 502 has been developed (and the second set of parts 506 of the first layer of material 502 have been removed). The first set of parts 504 of the first layer of material 502 provide intermediate pattern features 504 having sidewalls 508. The sidewalls 508 extend in a direction which is substantially perpendicular to the surface of the substrate 500.

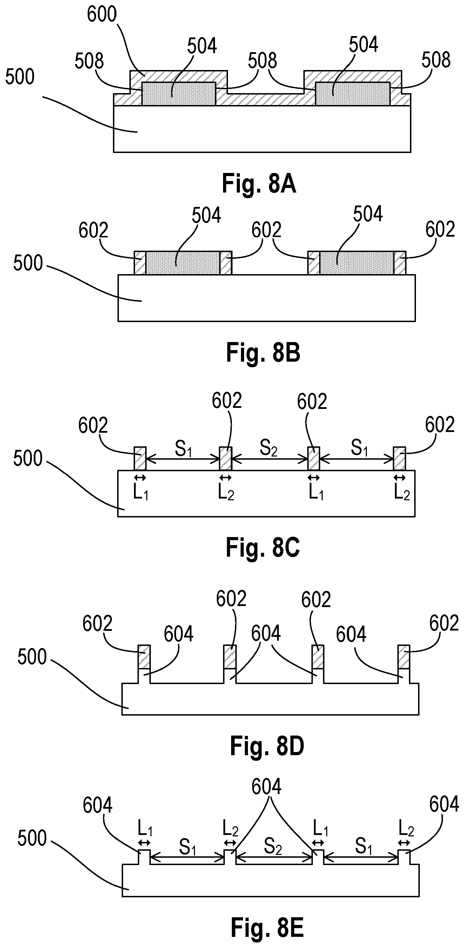

In some embodiments, one or more features may be formed using a multiple patterning or spacer lithography process. For example, the method according to the first aspect may be a self-aligned double patterning (SADP) process or a self-aligned quadrupole patterning (SAQP) process. An example of an SADP process with now be briefly described with reference to Figures 8A to 8E.

Figure 8A shows a second layer of material 600 that has been provided over the intermediate pattern features 504 shown in Figure 7D. The second layer of material 600 coats the sidewalls 508 of the intermediate pattern features 504. The second layer of material 600 may be referred to as a conformal layer, since the second layer of material 600 conforms to the shape of the intermediate pattern features 504.

Figure 8B shows that a portion of the second layer of material 600 has been removed, for example by etching or the like. A coating 602 of the second layer of material remains on (e.g. covering or coating) the sidewalls 508 of the intermediate pattern features 604. The coatings 602 of the second layer of material which remain on the sidewalls 508 of the intermediate pattern features 504 may be referred to as spacers, for example in the process that is currently being described - a spacer lithography process. Thus, it is understood that the term "spacer" is used, and may be used throughout this description, to describe the coating of a second layer of material on sidewalls 508 of the intermediate pattern features 504. The intermediate pattern features 504 are then removed, for example by etching or chemical processing or the like.

Figure 8C shows that the intermediate pattern features have been removed. In removing the intermediate pattern features, left on the substrate 500 are at least parts of the second layer of material that formed the coatings 602 on sidewalls of the intermediate pattern features (that have now been removed). This material 602 thus now forms pattern features on the substrate 500 in locations that are adjacent to the locations of the sidewalls of the removed first pattern features. Hereinafter, the material 602 is referred to as pattern features 602. From a comparison of Figures 7D and 8C it can be seen that the pattern features 602 of Figure 8C have half the pitch of the intermediate pattern features 604 of Figure 7D. This halving in pitch has been achieved not by reducing the wavelength of the radiation used to provide such pattern features, but has instead been achieved by appropriate processing (e.g. the provision and removal of layers) before and after a single exposure.

Also shown in Figure 8C are various spacings and widths: S₁ is a spacing between pattern features 602 that were formed on sidewalls either side of a intermediate pattern feature; S₂ is a spacing between pattern features 602 formed adjacent to sidewalls of adjacent and different intermediate pattern features; L₁ is the width (or in other words line width) of a pattern feature 602 formed adjacent to a first side wall of an intermediate pattern feature; L₂ is the width (or in other words line width) of a pattern feature 602 formed adjacent to a second, opposite side wall of the intermediate pattern feature.

In order to create uniformly structured and spaced pattern features it is desirable that S₁ is equal to S₂, and that L₁ is equal to L₂. As will be appreciated from a review of Figures 7A to 8C and the descriptions thereof, the spacing S₁ is primarily determined by the exposure processes which are associated with the creation of the intermediate pattern feature 604 (see for example Figures 7B to 7D). The spacing S₂ is also determined by the exposure processes which are associated with the creation of the intermediate pattern feature 504 (see for example Figures 7B to 7D), but also on the provision of the second layer of material 600 (shown in Figure 8A) and the subsequent removal of a part of that second layer of material 600 (shown in Figure 8B). The line widths L₁ and L₂ of the pattern features 602 are determined by the thickness of the second layer of material 600 that is provided (see for example Figure 8A) and also on the subsequent removal of the part of the second layer of material 600 (see Figure 8B).

The process shown in Figures 8A to 8C may be continued. It is to be understood that the pattern features shown in Figure 8C may be transferred to the substrate 500. Figure 8D shows how regions of the substrate 500 which are not shielded by the pattern features 602 can be partially removed, for example by etching or the like. Regions shielded by the pattern features 602 form pattern features 604, which are formed from the same material as the substrate 500. The pattern features 602 formed from the second layer of material 600 are then removed, for example by etching or the like. Figure 8E shows the substrate 500 when the pattern features formed from the second layer of material 600 have been removed.

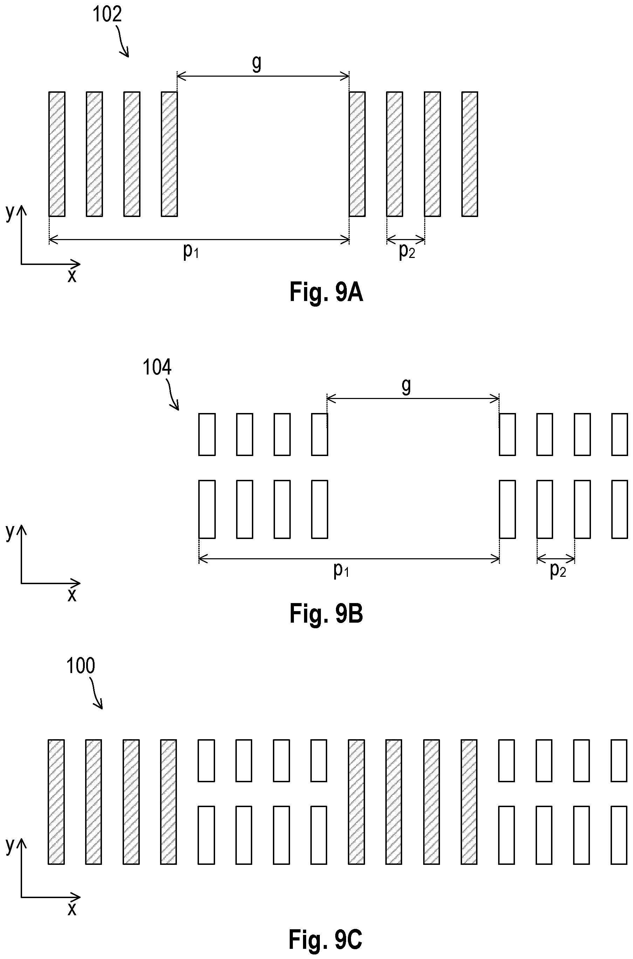

Some embodiments of the present disclosure relate to a new type of metrology target, as now discussed with reference to Figures 9A to 11.

Figure 9A shows a first portion 102 of a first example of the new type of metrology target; Figure 9B shows a second portion 104 of the first example of the new type of metrology target; and Figure 9C shows the first example of the new type of metrology target 100.

The metrology target 100 comprises: the first portion 102 that is at least partially formed by a first patterning process; and the second portion 104 that is at least partially formed by a second patterning process.

The first and second portions 102, 104 comprise substantially the same pattern in a first direction (the x-direction in Figures 9A to 9C). In particular, the first and second portions 102, 104 are each periodic in the first direction, have a first pitch (p₁) in the first direction and have a unit cell in the first direction comprising a set of at least two gratings. In this example, the first and second portions 102, 104 can each be considered to have a unit cell in the first direction (the x-direction) comprising a set of four lines.

As can be seen from Figures 9A and 9B, each set of at least two gratings is separated in the first direction by a gap g. Therefore, in addition to the set of at least two lines, the unit cell of each of the first and second portions 102, 104 comprises the gap g.

As can be seen in Figure 9C, the first and second portions 102, 104 are generally mutually interleaved such that, at least in a central portion of the metrology target 100, each set of at least two gratings of the first 102 portion is positioned between two adjacent sets of at least two gratings of the second portion 104 (in the gap g) and each set of at least two gratings of the second 104 portion is positioned between two adjacent sets of at least two gratings of the first portion 102 (in the gap g).

The first and second portions 102, 104 have the different pattern in a second direction (the y-direction in Figures 9A to 9C) that is generally perpendicular to the first direction. In this example, the gratings of the second portion 104 have been cut whereas the gratings of the first portion 102 have not.

In the art a misalignment of a first patterning process and a second patterning process is referred to as "overlay".

The new type of metrology target 100 may be of a type referred to as an in device metrology (IDM) target. Typically, such IDM targets may have features with dimensions that are comparable to those of features in the devices formed during the patterning processes.

The new type of metrology target 100 may be used to determine a parameter of a patterning process optically as follows. Radiation may be projected onto and scattered by the target 100. For example, the target may be under-filled. An asymmetry of reflected (or zeroth order scattered) radiation in a pupil plane (i.e. a Fourier transform plane to the plane of the target 100) is determined. This asymmetry is correlated to overlay and therefore overlay can be determined from the asymmetry. The overlay may, for example, be determined using metrology apparatus and/or methods of the type disclosed in WO2017/149009, which is incorporated herein by reference in its entirety.

The new type of metrology target 100 is advantageous for a number of reasons, as now discussed. In particular, the new type of metrology target 100 allows for a simple optical measurement of overlay for processes that combine self-aligned double patterning (SADP) methods and litho-etch-litho-etch (LELE) methods. Combining SADP and LELE methods allows for a significant increase in the density of features that can be formed using a given wavelength and the new metrology target 100 enables such a process by allowing for accurate overlay measurements to be made.

Each of the first and second portions 102, 104 have a unit cell in the first direction comprising a set of at least two gratings. Each such set of gratings is at least partially formed by a patterning process. In particular, each such set of gratings may be formed using a self-aligned double patterning (SADP) or spacer patterning method of the type described above with reference to Figures 7A to 8E. For example, each such set of gratings may comprise 4 lines and may be formed using a self-aligned quadruple patterning (SAQP) method. Furthermore, since the first and second portions 102, 104 are generally mutually interleaved the gratings from each of the first and second portions 102, 104 of the new metrology target 100 generally do not overlap. Such an arrangement is particularly beneficial for measuring overlay between two exposures that are formed in a single exposure layer (via two or more separate exposures). Such an exposure process may be referred to as a litho-etch-litho-etch (LELE) process. With such an LELE process product features formed on the current layer of the wafer W may comprise two portions (which are formed using separate exposures) and which are substantially identical. In general, it may be beneficial for metrology targets to be similar (for example as similar as possible) to the features formed on products being exposed in the current exposure layer. Since the first and second portions 102, 104 of the new metrology target 100 (which are at least partially formed during separate patterning processes) comprise substantially the same pattern in the first direction (the x-direction) they can be as similar to product features as possible. In fact, they can each be partially formed from patterns on a reticle that are identical to patterns on a reticle that are used for the formation of process features. Subsequently, at least one of the first and second portions 102, 104 may be subject to one or more cuts such that the first and second portions 102, 104 have the different pattern in the second direction (the y-direction).

The first and second portions 102, 104 have the different pattern in a second direction (the y-direction) that is generally perpendicular to the first direction and, advantageously, this ensures that any asymmetry of the first and second portions 102, 104 is correlated to overlay of the two patterning processes, as will be discussed further below, allowing overlay to be measured. In particular, they ensure that there is a correlation between a misalignment of the first and second exposures 102, 104 (i.e. overlay) and an asymmetry of a radiation beam reflected by the metrology target.

In some embodiments of the metrology target 100, the first portion 102 and the second portion 104 are formed in the same exposure layer of an object (e.g. a wafer W). In the art, a litho-etch-litho-etch process (LELE) is the formation of a single layer using multiple patterning processes. At present, metrology targets for such LELE processes are typically measured using a scanning electron microscopes. However, the new metrology target 100 will allow for optical measurement of such parameter of a patterning process .

In some embodiments of the metrology target 100, each set of at least two gratings of the first portion 102 and the second portion 104 are formed using a self-aligned double patterning method (for example of the type described above with reference to Figures 7A to 8E). Such a method may alternatively be referred to as a spacer patterning method. For example, each such set of gratings may comprise 4 lines and may be formed using a self-aligned quadruple patterning (SAQP) method.

For example, the first patterning process may form a single grating in each unit cell of the first portion 102. Similarly, the second patterning process may form a single grating in each unit cell of the second portion 104. Subsequently, a self-aligned double patterning (SADP) method may be used to convert each such grating into at least two gratings.

In some embodiments of the metrology target 100, the gratings of the first portion 102 and the second portion 104 have a dimension that is of the same order of magnitude as product features. This is advantageous since, in practice, the first and second patterning processes may be optimized for printing product features. Therefore, the closer the metrology target is in structure to such product features the better the overlay mark will be imaged.

In some embodiments of the metrology target 100, each set of at least two gratings of the first and second portions 102, 104 may be periodic in the first direction (the y-direction) and may have a second pitch (p₂). In some embodiments, the second pitch (p₂) may be of the order of 50 nm or less. For example, on average the second pitch (p₂) may be of the order of 50 nm. However, in some embodiments, the second pitch (p₂) may be as small as 40 nm or 30 nm or smaller. A pitch of the first and/or second portions 102, 104 in the second direction (the y-direction in Figures 9A to 9C) may, for example, be less than 150 nm.

In some embodiments of the metrology target 100, each set of at least two gratings of the first and second portions 102, 104 may comprise n lines and a pitch (p₂) of each set of gratings in the first direction may be the first pitch divided by 2n (p₂=p₁/2n).

The first and second portions 102, 104 of the metrology target 100 of the first aspect of the present disclosure have the different pattern in the second direction. This may be achieved in a number of different ways. For example, the sets of at least two gratings of the first portion 102 may have different lengths to those of the second portion 104. Additionally or alternatively, the sets of at least two gratings of at least one of the first portion 102 and the second portion 104 may be cut to form one or more breaks in the gratings.

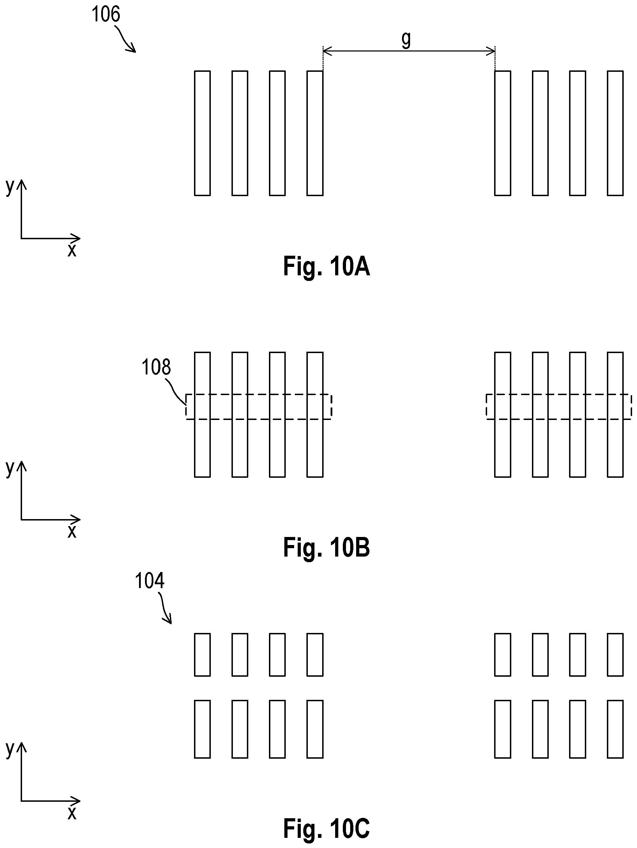

For example, as shown schematically in Figures 10A to 10C, the second portion 104 may be formed by first forming a pattern 106 comprising sets of 4 lines separated by a gap g (see Figure 10A). This pattern 106 may be generally identical to the pattern of the first portion 102 (although may be generally 180° out of phase with the first portion 102 so that the first and second portions are generally mutually interleaved). As shown schematically in Figure 10B, this pattern 106 may then be modified by making one or more cuts 108 through each set of gratings. Following these cuts 108, the second portion 104 may result (see Figure 10C). Note that, as shown schematically in Figures 10A to 10C, the cuts 108 may be formed once the sets of 4 lines have been formed (for example using a self-aligned quadruple patterning (SAQP) method). Alternatively, single lines may be formed, then cuts 108 may be made and then subsequently each of the cut lines may be used to form a set of 4 cut lines (for example using a self-aligned quadruple patterning (SAQP) method).

In some embodiments of the metrology target 100, at least one of the first and second portions 102, 104 may comprise one or more additional features in the second direction (the γ-direction). For example, the one or more additional features may comprise a segmentation of the sets of at least two gratings of at least one of the first and second portions 102, 104. Such a segmentation may comprise a line-cut and/or a fin-cut.

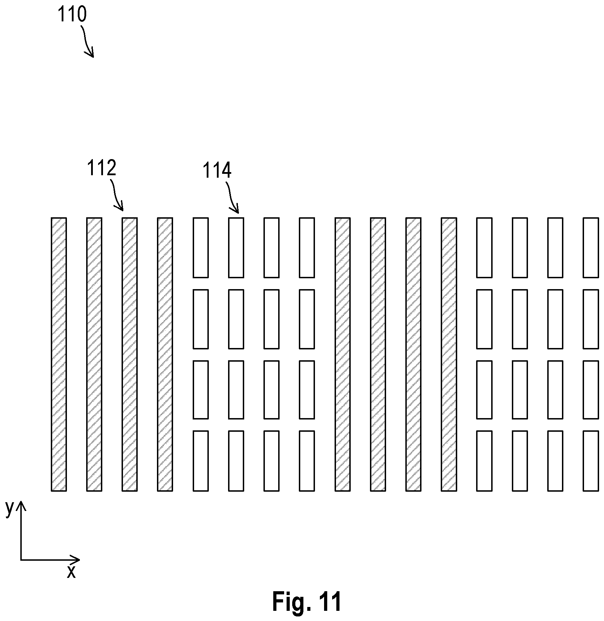

Figure 11 shows a second example 110 of the new type of metrology target comprising a first portion 112 and a second portion 114. The second example 110 of the new type of metrology target is very similar to the first example 100 of the new type of metrology target although, in this second example, the gratings of the second portion 114 have been subject to three cuts (whereas the gratings of the first portion 112 have not).
metrology targetmetrology targetmetrology targetmetrology targetmetrology targetmetrology targetThe inventors found that for the metrology target of the type described above wherein the two portions of the metrology target are identical in the first direction but have a different pattern in the second direction (for example one portion has been cut to form short gratings or bricks), there is a clear correlation between overlay and the norm(Intensity) of the antisymmetric cross polarized pupil. Therefore, with such a new metrology target there will be a clear IDM signal. Furthermore and in contrast, the inventors found that for the metrology target of the type described above wherein the two portions of the metrology target are identical (in both the first and second directions) there is no such correlation between overlay and the norm(Intensity) of the antisymmetric cross polarized pupil.

Some embodiments of the present disclosure may relate to a method for forming a metrology target 100 of the type described above. Such a method 200 is shown schematically in Figure 14 and is now discussed.

The method 200 comprises: a step 210 of performing a first patterning process to at least partially form the first portion 102; and a step 220 of performing a second patterning process to at least partially form the second portion 104.

In some embodiments of the method 200, the first portion 102 and the second portion 104 may be formed in the same exposure layer of an object (e.g. a wafer). In the art, a litho-etch-litho-etch process (LELE) is the formation of a single layer using multiple patterning processes. At present, metrology targets for such LELE processes are typically measured using a scanning electron microscopes.

In some embodiments of the method 200, each set of at least two gratings of the first portion 102 and the second portion 104 may be formed (at steps 210 and 220) using a self-aligned double patterning method. Such a method may alternatively be referred to as a spacer patterning method. For example, each such set of gratings may comprise 4 lines and may be formed using a self-aligned quadruple patterning (SAQP) method.

For example, the first patterning process 210 may form a single grating in each unit cell of the first portion. Similarly, the second patterning process may form a single grating in each unit cell of the second portion. Subsequently, a self-aligned double patterning (SADP) method may be used to convert each such grating into at least two gratings.

Optionally, the method 200 may further comprise at least one additional patterning process 230 to form features in at least one of the first and second portions 102, 104 in the second direction. For example, the one or more additional features may comprise a segmentation of the sets of at least two gratings of at least one of the first and second portions 102, 104. For example, the segmentation may comprise a line-cut and/or a fin-cut.

Some embodiments of the present disclosure may relate to a kit of parts for forming a metrology target 100 of the type described above. In general, such a kit of parts may comprise: at least one first patterning device for forming the first portion 102 of the metrology target 100; and at least one second patterning device for forming the second portion 104 of the metrology target 100. In some embodiments, the kit of parts may comprise at least two patterning devices for forming at least one of the first portion 102 of the metrology target 100 and the second portion 104 of the metrology target 100. For example, a patterning device (a mask or reticle) may be provided for forming a periodic pattern 106 in the first direction (cf. Figure 10A) and another patterning device (a mask or reticle) may be provided for forming one or more cuts 108 in a second direction (cf. Figure 10C). Some embodiments of the present disclosure may relate to a patterning device for forming the new metrology target 100 described above.

Some embodiments of the present disclosure may relate to a computer program product comprising a computer non-transitory readable medium having a data structure recorded thereon. The data structure may correspond to the new metrology target 100 described above and/or the method 200 described above.

Further embodiments are disclosed in the subsequent list of numbered clauses:
1. A target configured for measuring a parameter of a patterning process comprising:
   a first portion at least partially formed by a first patterning process; and
   a second portion at least partially formed by a second patterning process;
      wherein the first and second portions comprise substantially the same pattern in a first direction, the first and second portions are each periodic in a first direction, have a first pitch (p1) in the first direction and have a unit cell in the first direction comprising a set of at least two gratings;
      wherein the first and second portions are generally mutually interleaved such that at least in a central portion of the target, each set of at least two gratings of one of the first and second portions is positioned between two adjacent sets of at least two gratings of the other one of the first and second portions; and
   wherein the first and second portions have the different pattern in a second direction that is generally perpendicular to the first direction.
2. The target of clause 1 wherein the first portion and the second portion are formed in the same exposure layer of an object.
3. The target of clause 1 or clause 2 wherein each set of at least two gratings of the first portion and the second portion are formed using a self-aligned double patterning method.
4. The target of any preceding clause wherein the gratings of the first portion and the second portion have a dimension that is of the same order of magnitude as product features.
5. The target of any preceding clause wherein each set of at least two gratings of the first and second portions is periodic in the first direction and has a second pitch (p2).
6. The target of clause 5 wherein the second pitch (p2) is of the order of 50 nm or less.
7. The target of any preceding clause wherein each set of at least two gratings of the first and second portions comprises n lines and wherein a pitch (p2) of each set of gratings in the first direction is the first pitch divided by 2n (p2=p1/2n).
8. The target of any preceding clause wherein at least one of the first and second portions comprises one or more additional features in the second direction.
9. The target of clause 8 wherein the one or more additional features comprises a segmentation of the sets of at least two gratings of at least one of the first and second portions.
10. The target of clause 9 wherein the segmentation comprises a line-cut and/or a fin-cut.
11. A method for forming a target configured for measuring a parameter of a patterning process comprising first and second portions, the method comprising:
   performing a first patterning process to at least partially form the first portion; and
   performing a second patterning process to at least partially form the second portion;
      wherein the first and second portions comprise substantially the same pattern in a first direction, the first and second portions are each periodic in a first direction, have a first pitch (p1) in the first direction and have a unit cell in the first direction comprising a set of at least two gratings;
      wherein the first and second portions are generally mutually interleaved such that at least in a central portion of the target, each set of at least two gratings of one of the first and second portions is positioned between two adjacent sets of at least two gratings of the other one of the first and second portions; and
   wherein the first and second portions have the different pattern in a second direction that is generally perpendicular to the first direction.
12. The method of clause 11 wherein the first portion and the second portion are formed in the same exposure layer of an object.
13. The method of clause 11 or clause 12 wherein each set of at least two gratings of the first portion and the second portion are formed using a self-aligned double patterning method.
14. The method of any preceding clause wherein the gratings of the first portion and the second portion have a dimension that is of the same order of magnitude as product features.
15. The method of any preceding clause wherein each set of at least two gratings of the first and second portions is periodic in the first direction and has a second pitch (p2).
16. The method of clause 15 wherein the second pitch (p2) is of the order of 50 nm or less.
17. The method of any one of clauses 11 to 16 further comprising at least one additional patterning process to form features in at least one of the first and second portions in the second direction.
18. The method of clause 17 wherein the one or more additional features comprises a segmentation of the sets of at least two gratings of at least one of the first and second portions.
19. The method of clause 18 wherein the segmentation comprises a line-cut and/or a fin-cut.
20. A kit of parts for forming the target of any one of clauses 1 to 10, the kit of parts comprising:
   at least one first patterning device for forming the first portion of the target; and
   at least one second patterning device for forming the second portion of the metrology target.
21. The kit of parts of clause 20 comprising at least two patterning devices for forming at least one of the first portion of the metrology target and the second portion of the target.
22. A patterning device for forming the target of any one of clauses 1 to 10.
23. A computer program product comprising a computer non-transitory readable medium having a data structure recorded thereon, the data structure corresponding to the metrology target of any one of clauses 1 to 10 and/or the method according any one of clauses 11 to 19.

Although specific reference is made to "metrology apparatus / tool / system" or "inspection apparatus / tool / system", these terms may refer to the same or similar types of tools, apparatuses or systems. For example, the inspection or metrology apparatus that comprises an embodiment of the invention may be used to determine characteristics of structures on a substrate or on a wafer. For example, the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may be made in this text to the use of exposure apparatus in the manufacture of ICs, it should be understood that the exposure apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an exposure apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An metrology target configured for measuring a parameter of a patterning process comprising:
a first portion at least partially formed by a first patterning process; and
a second portion at least partially formed by a second patterning process;
wherein the first and second portions comprise substantially the same pattern in a first direction, the first and second portions are each periodic in a first direction, have a first pitch in the first direction and have a unit cell in the first direction comprising a set of at least two gratings;
wherein the first and second portions are generally mutually interleaved such that at least in a central portion of the metrology target, each set of at least two gratings of one of the first and second portions is positioned between two adjacent sets of at least two gratings of the other one of the first and second portions; and
wherein the first and second portions have the different pattern in a second direction that is generally perpendicular to the first direction.

2. The metrology target of claim 1 wherein the first portion and the second portion are formed in the same exposure layer of an object.

3. The metrology target of claim 1 or claim 2 wherein each set of at least two gratings of the first portion and the second portion are formed using a self-aligned double patterning method.

4. The metrology target of any preceding claim wherein the gratings of the first portion and the second portion have a dimension that is of the same order of magnitude as product features.

5. The metrology target of any preceding claim wherein each set of at least two gratings of the first and second portions is periodic in the first direction and has a second pitch.

6. The metrology target of claim 5 wherein the second pitch is of the order of 50 nm or less.

7. The metrology target of any preceding claim wherein each set of at least two gratings of the first and second portions comprises n lines and wherein a pitch of each set of gratings in the first direction is the first pitch divided by 2n.

8. The metrology target of any preceding claim wherein at least one of the first and second portions comprises one or more additional features in the second direction.

9. The metrology target of claim 8 wherein the one or more additional features comprises a segmentation of the sets of at least two gratings of at least one of the first and second portions.

10. A method for forming a metrology target configured for measuring a parameter of a patterning process comprising first and second portions, the method comprising:
performing a first patterning process to at least partially form the first portion; and
performing a second patterning process to at least partially form the second portion;
wherein the first and second portions comprise substantially the same pattern in a first direction, the first and second portions are each periodic in a first direction, have a first pitch in the first direction and have a unit cell in the first direction comprising a set of at least two gratings;
wherein the first and second portions are generally mutually interleaved such that at least in a central portion of the metrology target, each set of at least two gratings of one of the first and second portions is positioned between two adjacent sets of at least two gratings of the other one of the first and second portions; and
wherein the first and second portions have the different pattern in a second direction that is generally perpendicular to the first direction.

11. The method of claim 10 wherein the first portion and the second portion are formed in the same exposure layer of an object.

12. The method of claim 10 or claim 11 wherein each set of at least two gratings of the first portion and the second portion are formed using a self-aligned double patterning method.

13. A kit of parts for forming the metrology target of any one of claims 1 to 9, the kit of parts comprising:
at least one first patterning device for forming the first portion of the metrology target; and
at least one second patterning device for forming the second portion of the metrology target.

14. A patterning device for forming the metrology target of any one of claims 1 to 9.

15. A computer program product comprising a computer non-transitory readable medium having a data structure recorded thereon, the data structure corresponding to the metrology target of any one of claims 1 to 9 and/or the method according any one of claims 10 to 12.
